Europäisches Patentamt

European Patent Office

Office européen des brevets

(19)

(11) Publication number: **0 429 160 A2**

## EUROPEAN PATENT APPLICATION

(12)

(21) Application number: **90302340.6**

(22) Date of filing: **06.03.90**

(51) Int. Cl.⁵: **G11C 5/00, G11C 5/06**

(30) Priority: **20.11.89 JP 134966/89 U**

(43) Date of publication of application:
**29.05.91 Bulletin 91/22**

(84) Designated Contracting States:
**BE DE ES FR GB IT LU NL SE**

(71) Applicant: **SNK CORPORATION**
**18-12, Toyotsu-cho**
**Suita-shi, Osaka(JP)**

(72) Inventor: **Hasegawa, Yoshihiko**
**35-12 Higashitoyonaka-cho, 5-chome**
**Toyonaka-shi, Osaka(JP)**

(74) Representative: **Milhench, Howard Leslie et al**
**R.G.C. Jenkins & Co. 26 Caxton Street**
**London SW1H 0RJ(GB)**

(54) Memory cartridge for use with TV game machine.

(57) A memory cartridge for use with a TV game machine. It has a plurality of memories containing picture images such as game characters, messages and letters, a memory containing a sound program and a memory for synthesizing sound. The memories containing picture images have their data buses connected to a pin connector through a parallel-serial converter circuit to reduce the number of pins forming the pin connector.

EP 0 429 160 A2

## MEMORY CARTRIDGE FOR USE WITH TV GAME MACHINE

The present invention relates to a memory cartridge for use with a TV game machine, specifically a home TV game machine.

In using this type of game machine, a memoty cartridge containing a program for a desired game is connected to the game machine to load the machine with the program. Such a cartridge usually has memories containing programs and characters.

Today's game software is required to be capable of representing realistic characters, pictures and backgrounds as well as producing sound and background music with high fidelity. For this purpose, the game cartridges have to have a suff icient memory capacity. The larger the memory capacity of a cartridge, the larger the number of its connector pins for data transfer and thus the size of the cartridge itself. This leads to an increase in the size of a loading slot in a game machine and thus an increase in the size of the game machine itself.

It is an object of the present invention to provide a memory cartridge which can do with a minimum number of connector pins.

In accordance with the present invention, there is provided a memory cartridge for use with a TV game machine, comprising a plurality of non-volatile memories containing picture images such as game characters, messages and letters, a non-volatile memory containing a sound program, a non-volatile memory for synthesizing sound, a non-volatile memory containing a game main program, and a parallel-serial converter circuit connected to the data buses of the non-volatile memories containing picture images.

A picture on a screen consists of a plurality of unit characters, each of which consists of e.g. 16 x 16 dots. Each dot consists of four bits. Thus a huge memory capacity is required to display a complicated picture. Thus a plurality of ROMs are needed to memorize such pictures. The number of bits fed from these ROM's through their data buses will exceed the processing capacity of a picture processing circuit in the game machine. According to the present invention, the parallel-serial converter circuit is disposed between the ROM's and the connector pins in order to permit the picture processing in the game machine and at the same time to reduce the number of connector pins of the memory cartridge.

Other features and objects of the present invention will become apparent from the following description taken with reference to the accompanying drawings, in which:

Fig. 1 is an exploded perspective view of the embodiment according to the present invention;

Fig. 2 is a block diagram of the same; and

Fig. 3 is a block diagram of a TV game machine loaded with the cartridge according to the present invention.

The preferred embodiment according to the present invention will be described with reference to the accompanying drawings.

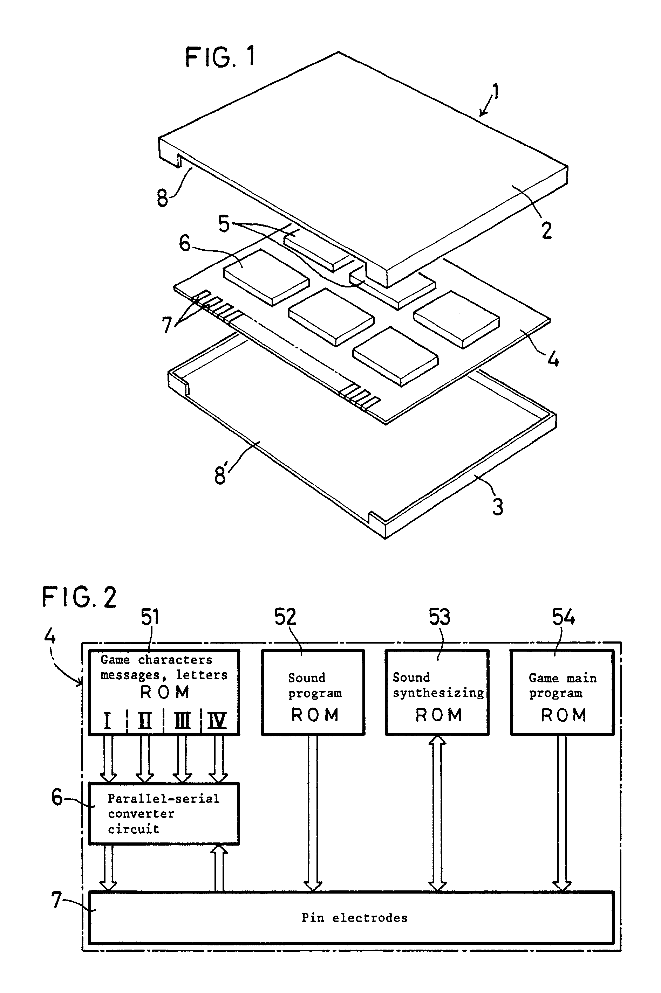

As shown in Fig. 1, a memory cartridge 1 comprises top and bottom covers 2 and 3 and a circuit wiring board 4. The top and bottom covers 2 and 3 are coupled together to form a casing to contain the circuit wiring board 4.

On the circuit wiring board 4 are mounted a plurality of non-volatile memories 5 such as ROM's and a parallel-serial converter circuit 6 in the form of an IC chip. They are connected to a pin connector 7 comprising a plurality of pin electrodes by suitable print wiring (not shown). The pin connector 7 is exposed at openings 8 and 8' formed in the front ends of the covers 2 and 3.

As shown in Fig. 2, the non-volatile memories 5 include a plurality of ROM's 51 containing such picture data as game characters, messages and letters, a ROM 52 for a sound program, a ROM 53 for synthesizing sound and a ROM 54 for a main program of the game. The picture ROM's 51 are connected to the pin connector 7 through the parallel-serial convertor circuit 6. The other ROM's 52, 53 and 54 are directly connected to the pin connector 7.

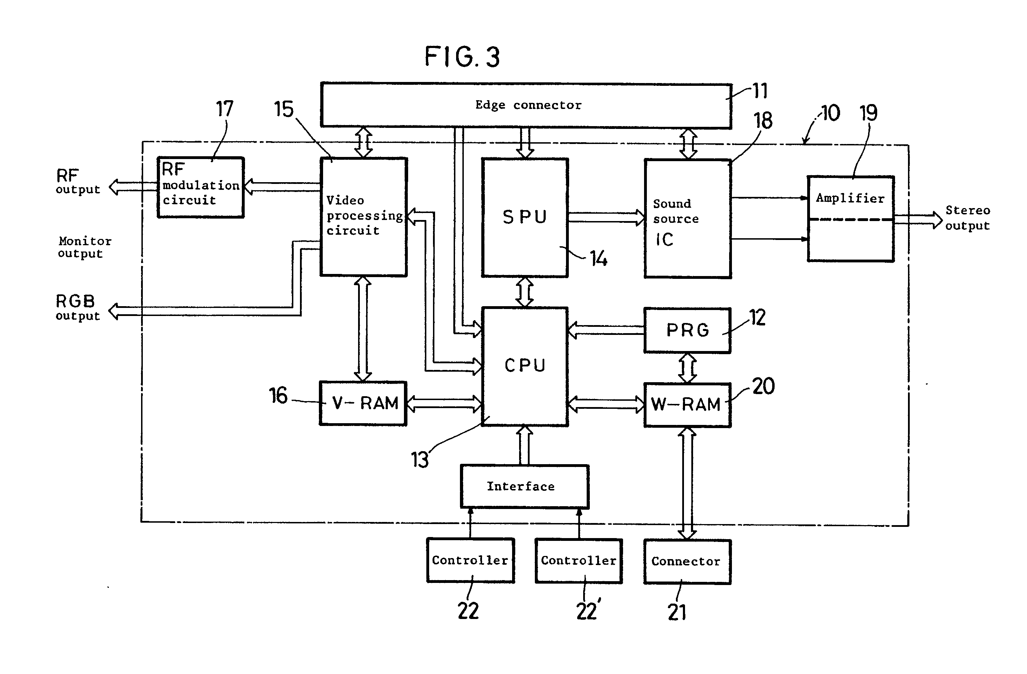

When the memory cartridge 1 is set in a game machine 10 shown in Fig. 3, the pin connector 7 is connected to an edge connector 11 of the game machine 10, allowing data transfer between the memory cartridge 1 and the game machine 10.

The game machine 10 contains a program (PRG) 12 which allows a central processing unit 13 (CPU such as 68000 CPU) and a sound processing unit 14 (SPU such as Z80 CPU) to gain access to the game main program ROM 54 and the sound program ROM 52, respectivley.

Upon start of the game, the main program will be executed by the CPU 13 by manipulating controllers 22, 22' and a video processing circuit 15 and the SPU 14 are controlled. The video processing circuit 15 obtains access to the picture ROM's 51 in accordance with the instructions of the CPU 13. The picture ROM's 51 contain e.g. 4 x 1024 characters, each character consisting of 16 x 16 dots, each dot consisting of 4 bits. Four 1-megabit ROM's are needed to store this amount of data.

Multicolor representation is of course impossible with four-bit per dot. This four-bit per dot information is used only to specify the color storage number in a palette stored in RAM's (not shown) to which the video processing circuit can gain access. A V-RAM 16 contains a table showing in a one-to-one relationship the number and position of each character on the monitor as well as an area for sprite. The video processing circuit 15 takes out the characters in the ROM's 51 while gaining access to the corresponding portions in the RAM 16 to give colors to the characters, which are then given as RGB signals. They may be outputted as RF signals after passing them through an RF modulation circuit

In the preferred embodiment, there are provided four ROM's 51 each having 32-bit data buses. On the other hand, the video processing circuit 15 has a dot serial output. For this type of video processor, an 8-bit one is usually sufficient. Thus, according to the present invention, a parallel-serial converter 16 is provided between the ROM's 51 and the video processing circuit 15 (Fig. 2) . This also leads to a reduction in the number of connector pins.

The sound processing unit 14 runs the sound program in the ROM 52 as the main program progresses, to give sound outputs to an amplifier 19 according to the content of the sound synthesizing ROM 53 which are memorized as digital information, by actuating a sound source IC 18.

A work RAM (W-RAM) 20 is a memory for temporarily storing e.g. the current status and score of the game. By transferring the content of this RAM through a connector 21 to an IC card having a backup power supply, the game can be continued even after the game machine has been turned off.

## Claims

1. A memory cartridge for use for example in a video game machine, the cartridge comprising a memory and a bus converter for converting data between a first bus sassociated with the memory and a second bus for transferring data between the cartridge and the game machine which second bus has fewer lines than the first bus thereby minimising the number of connections between the cartridge and the game machine.

2. A memory cartridge as claimed in claim 1, wherein she memory comprises a plurality of memory portions with each portion being arranged to store information relating to a part of a game.

3. A memory cartridge as claimed in claim 1 or claim 2, wherein at least part of the memory comprises at least one non-volatile read only memory (ROM) device.

4. A memory cartridge as claimed in claim 3, wherein the at least one ROM has a 32-bit data bus.

5. A memory cartridge as claimed in any preceding claim wherein the converter comprises a parallel/serial converter.

6. A memory cartridge as claimed in any preceding claiml wherein the second bus comprises an eight bit dot-serial bus.

7. A game machine adapted for use with a memory cartridge as claimed in any of the preceding claims.

8. A game machine as claimed in claim 7 further comprising means for storing information relating to the status of a game.

9. A memory cartridge as claimed in any of claims 1 to 6 in use in a game machine.

10. A memory cartridge for use with a TV game machine, comprising a plurality of non-volatile memories containing picture images such as game characters, messages and letters, a non-volatile memory containing a sound program, a non-volatile memory for synthesizing sound, a non-volatile memory containing a game main program, and a parallel-serial converter circuit connected to the data buses of said non-volatile memories containing picture images.

## FIG. 1

## FIG. 2

| Game characters messages, letters ROM | Sound program ROM | Sound synthesizing ROM | Game main program ROM |
|---|---|---|---|
| I   II   III   IV | | | |

Parallel-serial converter circuit

Pin electrodes

4

## FIG. 3

EP 0 429 160 A2